(19) Europäisches Patentamt
European Patent Office
Office européen des brevets

(11) **EP 2 086 030 B1**

(12) **EUROPEAN PATENT SPECIFICATION**

(45) Date of publication and mention
of the grant of the patent:
**10.04.2013 Bulletin 2013/15**

(51) Int Cl.:
*H01L 41/187* (2006.01)   *H01L 41/43* (2013.01)
*C04B 35/499* (2006.01)   *C01G 33/00* (2006.01)
*C01G 53/00* (2006.01)   *C04B 35/493* (2006.01)
*C04B 35/628* (2006.01)   *C04B 35/626* (2006.01)

(21) Application number: **09250226.9**

(22) Date of filing: **28.01.2009**

(54) **Piezoelectric/electrostrictive ceramics and process for producing the same**

Piezoelektrische/elektrostriktive Keramik und Verfahren zu deren Herstellung

Céramiques piézoélectriques/électrostrictives et leur procédé de fabrication

(84) Designated Contracting States:
**DE**

(30) Priority: **30.01.2008 JP 2008019076**

(43) Date of publication of application:
**05.08.2009 Bulletin 2009/32**

(73) Proprietor: **NGK Insulators, Ltd.
Nagoya-shi, Aichi 467-8530 (JP)**

(72) Inventors:
• **Kashiwaya, Toshikatsu
Nagoya City
Aichi-ken, 467-8530 (JP)**
• **Ebigase, Takashi
Nagoya City
Aichi-ken, 467-8530 (JP)**

(74) Representative: **Naylor, Matthew John et al
Mewburn Ellis LLP
33 Gutter Lane
London
EC2V 8AS (GB)**

(56) References cited:
**EP-A2- 1 191 611       JP-A- 2000 247 737
JP-A- 2007 204 336**

• **TIEN-I CHANG ET AL: "The formation mechanism
of the novel core-shell microstructure in
polyvinyl alcohol-additive lead zirconate titanate
films", JOURNAL OF THE AMERICAN CERAMIC
SOCIETY AMERICAN CERAMIC SOC. USA, vol.
90, no. 4, April 2007 (2007-04), pages 1051-1057,
XP002667381, ISSN: 0002-7820**

**Description**

BACKGROUND OF THE INVENTION

Field of the Invention

The present invention relates to piezoelectric/electrostrictive ceramics that exhibit only a small change in properties after polarization, high insulating properties, and narrow variations in durability, and to a process for producing such piezoelectric/electrostrictive ceramics.

Description of the Background Art

Piezoelectric/electrostrictive actuators have the advantage of precise displacement control of the order of submicrons. In particular, piezoelectric/electrostrictive actuators employing a sintered piezoelectric/electrostrictive ceramic body as a piezoelectric/electrostrictive body have the advantages of, in addition to precise displacement control, high electromechanical conversion efficiency, high generative power, fast response speed, great durability, and low power consumption. With these advantages, they are used for equipment such as inkjet printer heads, diesel engine injectors, hydraulic servo valves, VTR heads, and pixels in piezoelectric ceramic displays.

Among them, NiO-doped Lead Magnesium Niobate (Pb(Mg$_{1/3}$Nb$_{2/3}$)O$_3$)- Lead Titanate (PbTiO$_3$)- Lead Zirconate (PbZrO$_3$) piezoelectric/electrostrictive ceramics have high electric-field-induced strains and thus are preferably used for piezoelectric/electrostrictive actuators (cf., for example, Japanese Patent Application Laid-open No. 2002-100819, which is hereinafter referred to as "patent document 1"). Patent document 1 also discloses that nickel has a concentration gradient in the direction along the thickness of a piezoelectric/electrostrictive film.

The piezoelectric/electrostrictive ceramics disclosed in patent document 1, however, have such problems as a significant change in properties after polarization, low insulating properties, and wide variations in durability.

Further methods and products according to the state of the art are described by JP 2000-247737; Tien-I Chang et al., "The Formation Mechanism of the Novel Core-Shell Microstructure in Polyvinyl Alcohol-Additive Lead Zirconate Titanate Films", J. Am. Ceram. Soc., vol. 90, p. 1051-1057, (2007); and JP 2007-204336. Document EP 1 191 611 A2 corresponds to patent document 1.

SUMMARY OF THE INVENTION

It is an object of the present invention to provide piezoelectric/electrostrictive ceramics that exhibit only a small change in properties after polarization, high insulating properties, and narrow variations in durability.

According to an aspect of the invention, the piezoelectric/electrostrictive ceramic includes a perovskite oxide containing lead as an A-site component and magnesium, nickel, niobium, titanium, and zirconium as B-site components. Crystal grains in the piezoelectric/electrostrictive ceramic have a core/shell construction with a shell portion having a higher concentration of nickel than a core portion and with the core portion having a higher concentration of magnesium than the shell portion.

This piezoelectric/electrostrictive ceramic exhibits only a small change in properties after polarization, high insulating properties, and narrow variations in durability.

According to another aspect of the invention, a process for producing a piezoelectric/electrostrictive ceramic includes the following steps: (a) initiating a reaction between raw materials for first elements selected from among B-site components to form an intermediate, the first elements including magnesium and niobium and not including nickel; and (b) initiating a reaction between the intermediate synthesized in said step (a) and a raw material for a second element selected from among A-site and B-site components, the second element including nickel and not including magnesium. The steps (a) and (b) produce a piezoelectric/electrostrictive ceramic that includes a perovskite oxide containing lead as an A-site component and magnesium, nickel, niobium, zirconium, and titanium as B-site components.

This process produces a piezoelectric/electrostrictive ceramic that exhibits only a small change in properties after polarization, high insulating properties, and narrow variations in durability.

These and other objects, features, aspects and advantages of the present invention will become more apparent from the following detailed description of the present invention when taken in conjunction with the accompanying drawings.

BRIEF DESCRIPTION OF THE DRAWINGS

Fig. 1 is a cross-sectional view of a piezoelectric/electrostrictive element;

Figs. 2 and 3 are ternary diagrams for explaining the range of composition of a piezoelectric/electrostrictive material;

Fig. 4 is a diagrammatic illustration of a microstructure of a crystal grain;

Fig. 5 is a flowchart for explaining a process for producing a piezoelectric/electrostrictive element;

Fig. 6 is a flowchart for explaining a process for synthesizing a piezoelectric/electrostrictive material powder;

Fig. 7 is a cross-sectional view of a piezoelectric/electrostrictive element according to a second preferred embodiment;

Fig. 8 plots the electrical resistance value of the piezoelectric/electrostrictive element after a durability test;

Fig. 9 shows a magnesium distribution in a cross section of a piezoelectric/electrostrictive element; and

Fig. 10 shows a nickel distribution in the cross section of the piezoelectric/electrostrictive element.

## DESCRIPTION OF THE PREFERRED EMBODIMENTS

### <1. First Preferred Embodiment>

#### <1-1. Structure of Piezoelectric/Electrostrictive Element 1>

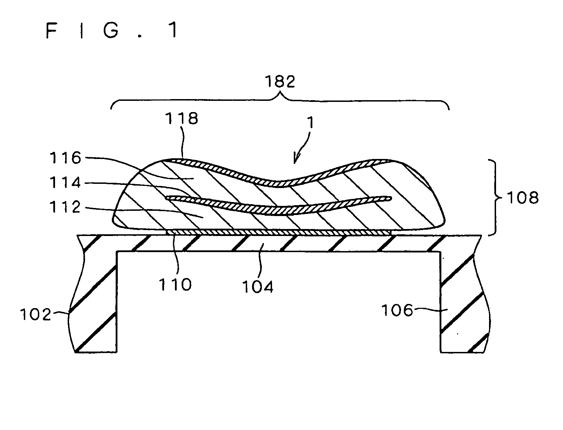

Fig. 1 is a diagrammatic illustration of the principal part of a piezoelectric/electrostrictive element 1 according to a first preferred embodiment of the invention, showing the piezoelectric/electrostrictive element 1 in cross section. The piezoelectric/electrostrictive element 1 in Fig. 1 is an actuator adopted in an inkjet printer head. This, however, is not meant to limit the application of the invention to only piezoelectric/electrostrictive elements for inkjet printer heads. The present invention may be applicable to, for example, various kinds of actuators or sensors.

As illustrated in Fig. 1, the piezoelectric/electrostrictive element 1 has a laminated structure in which an electrode film 110, a piezoelectric/electrostrictive film 112, another electrode film 114, another piezoelectric/electrostrictive film 116, and another electrode film 118 are laminated in order of mention on a thin portion 104 of a substrate 102.

While, in Fig. 1, only a single layer of electrode film 114 is within a laminated body 108 with the electrode film 110, the piezoelectric/electrostrictive film 112, the electrode film 114, the piezoelectric/electrostrictive film 116, and the electrode film 118 laminated on the substrate 102, the present invention is also applicable to the cases where two or more layers of electrode film are within the laminated body 108 or where no electrode film is within the laminated body 108. While in the case of Fig. 1 the laminated body 108 is formed directly on the substrate 102, the laminated body 108 may indirectly be formed on the substrate 102 with an inert layer therebetween. Alternatively, a plurality of piezoelectric/electrostrictive elements 1 may be arranged at regular intervals into an integral unit.

In the piezoelectric/electrostrictive element 1, a drive signal is applied between the electrode films 110, 118 as external electrodes and the electrode film 114 as an internal electrode so that an electric field is applied to the piezoelectric/electrostrictive films 112 and 116 to induce flexural oscillations of the thin portion 104 and the laminated body 108. Hereinafter, a region 182 in which such flexural oscillations are excited is referred to as a "flexural oscillation region."

#### <1-2. Substrate 102>

The substrate 102 supports the laminated body 108. The substrate 102 is a sintered ceramic body produced by firing laminated sheet compacts of a ceramic powder.

The substrate 102 is made of an insulating material. The insulating material should preferably be zirconium oxide ($ZrO_2$) with the addition of a stabilizer, such as calcium oxide (CaO), magnesium oxide (MgO), yttrium oxide ($Y_2O_3$), ytterbium oxide ($Yb_2O_3$), or cerium oxide ($Ce_2O_3$); that is, it should preferably be stabilized or partly stabilized zirconia.

The substrate 102 has a cavity structure with the central thin portion 104 surrounded and supported by a peripheral thick portion 106. The adoption of such a cavity structure, where the thin portion 104 with a smaller plate thickness is supported by the thick portion 106 with a larger plate thickness, allows a reduction in the thickness of the thin portion 104 while maintaining the mechanical strength of the substrate 102, thus reducing the stiffness of the thin portion 104 and increasing the displacement of the piezoelectric/electrostrictive element 1. The thin portion 104 should preferably have a plate thickness of 0.5 to 15 $\mu m$, more preferably, 0.5 to 10 $\mu m$. This is because the plate thickness below this range tends to cause damage to the thin portion 104, while the plate thickness above this range tends to reduce the displacement of the piezoelectric/electrostrictive element 1.

#### <1-3. Piezoelectric/Electrostrictive Films 112, 116>

The piezoelectric/electrostrictive films 112 and 116 are sintered ceramics body produced by firing a film compact of a ceramic powder.

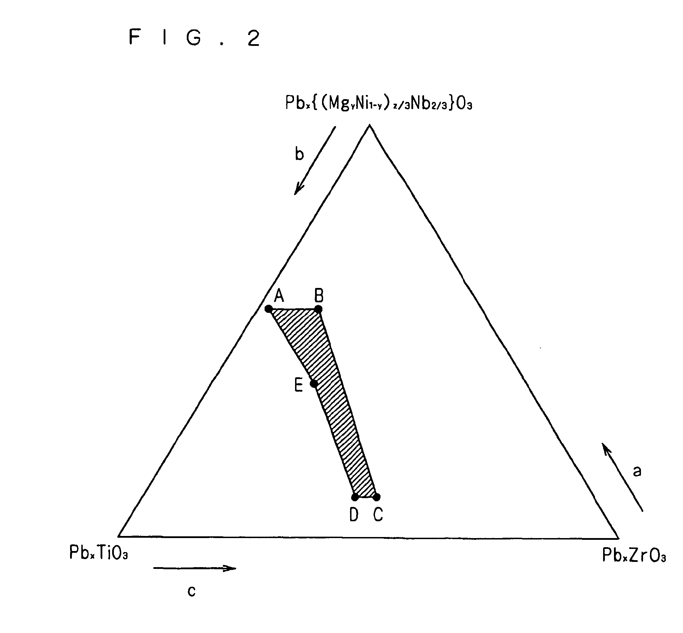

The piezoelectric/electrostrictive films 112 and 116 are made of a piezoelectric/electrostrictive material. The piezoelectric/electrostrictive films 112 and 116 should preferably include a perovskite oxide containing lead (Pb) as an A-site component and magnesium (Mg), nickel (Ni), niobium (Nb), titanium (Ti), and zirconium (Zr) as B-site components. In particular, the piezoelectric/electrostrictive films 112 and 116 should preferably be made of a piezoelectric/electrostrictive material having a composition represented by the general formula: $aPb_x\{(Mg_{1-y}Ni_y)_{z/3}Nb_{2/3}\}O_3\text{-}bPb_xTiO_3\text{-}cPb_xZrO_3$ , where $(a+b+c)=1$ , $0.95 \leq x \leq 1.10$, $0.05 \leq y \leq 0.50$, $0.90 \leq z \leq 1.10$, and the ratio of composition $(a,b,c)$ falls within the range defined by the five points, namely A(0.550, 0.425, 0.025), B(0.550, 0.325, 0.125), C(0.100, 0.425, 0.475), D(0.100, 0.475, 0.425), and E(0.375, 0.425, 0.200), in the ternary diagram in Fig. 2.

The variable $x$ is defined as $0.95 \leq x \leq 1.10$ because the variable $x$ below this range tends to degrade sintering properties of the piezoelectric/electrostrictive ceramics, while the variable $x$ above this range tends to increase segregating elements such as lead oxide (PbO), resulting in degraded insulating and moisture-resistant properties of the piezoelectric/electrostrictive ceramics.

The variable $y$ is defined as $0.05 \leq y \leq 0.50$ because the variable $y$ outside this range tends to result in lower electric-field-induced strains of the piezoelectric/electrostrictive ceramics.

The variable $z$ is defined as $0.90 \leq z \leq 1.10$ because the variable $z$ below this range tends to cause an excessive increase of donor components, resulting in degraded sintering properties of the piezoelectric/electrostrictive ceramics, while the variable $z$ above this range tends to cause an excessive increase of acceptor components, resulting in an excessive progress of the grain growth of the piezoelectric/electrostrictive ceramics.

The ratio of composition $(a,b,c)$ is made to fall within the range defined by the five points, namely A(0.550, 0.425, 0.025), B(0.550, 0.325, 0.125), C(0.100, 0.425, 0.475), D(0.100, 0.475, 0.425), and E(0.375, 0.425, 0.200), in the ternary diagram in Fig. 2 because the ratio of composition $(a,b,c)$ outside this range tends to cause the piezoelectric/electrostrictive ceramics to have a composition apart from the Morphotropic phase boundary, resulting in degraded piezoelectric/electrostrictive properties of the piezoelectric/electrostrictive ceramics.

A part of lead forming an A-site may be substituted with alkaline-earth metal elements such as calcium (Ca), strontium (Sr), or barium (Ba) or with rare-earth elements such as lanthanum (La) or neodymium (Nd). For improvement in the piezoelectric/electrostrictive properties, the piezoelectric/electrostrictive ceramics may further include at least one or more oxides selected from the group consisting of cerium oxide ($Ce_2O_3$), yttrium oxide ($Y_2O_3$), aluminum oxide ($Al_2O_3$), nickel oxide (NiO), niobium oxide ($Nb_2O_5$), and the like.

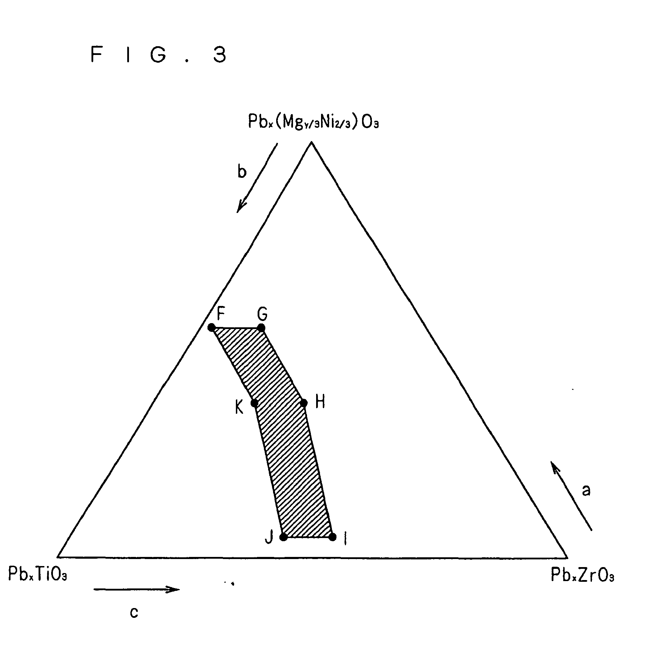

It is also preferable that the piezoelectric/electrostrictive films 112 and 116 be made of a piezoelectric/electrostrictive material whose principal component contains 0.1 to 3.0 percent by mass of NiO and has a composition represented by the general formula: $aPb_x(Mg_{y/3}Nb_{2/3})O_3\text{-}bPb_xTiO_3\text{-}cPb_xZrO_3$ , where $(a+b+c)=1$, $0.95 \leq x \leq 1,10$, $0.90 \leq y \leq 1.10$, and the ratio of composition $(a,b,c)$ falls within the range defined by the six points, namely F(0.550, 0.425, 0.025), G(0.550, 0.325, 0.125), H(0.375, 0.325, 0.300), I(0.050, 0.425, 0.525), J(0.050, 0.525, 0.425), and K(0.375, 0.425, 0.200), in the ternary diagram in Fig. 3.

The variable $x$ is defined as $0.95 \leq x \leq 1.10$ because the variable $x$ below this range tends to degrade sintering properties of the piezoelectric/electrostrictive ceramics, while the variable $x$ above this range tends to increase segregating elements such as lead oxide, resulting in degraded insulating and moisture-resistant properties of the piezoelectric/electrostrictive ceramics.

The variable $y$ is defined as $0.90 \leq y \leq 1.10$ because the variable $y$ below this range tends to cause an excessive increase of donor components, resulting in degraded sintering properties of the piezoelectric/electrostrictive ceramics, while the variable $y$ above this range tends to cause an excessive increase of acceptor components, resulting in an excessive progress of the grain growth of the piezoelectric/electrostrictive ceramics.

The ratio of composition $(a,b,c)$ is made to fall within the range defined by the six points, namely F(0.550, 0.425, 0.025), G(0.550, 0.325, 0.125), H(0.375, 0.325, 0.300), I(0.050, 0.425, 0.525), J(0.050, 0.525, 0.425), and K(0.375, 0.425, 0.200), in the ternary diagram in Fig. 3 because the ratio of composition $(a,b,c)$ outside this range tends to cause the piezoelectric/electrostrictive ceramics to have a composition apart from the Morphotropic phase boundary, resulting in degraded piezoelectric/electrostrictive properties of the piezoelectric/electrostrictive ceramics.

As illustrated in Fig. 1, the piezoelectric/electrostrictive films 112 and 116 have such a film thickness distribution that the film thickness increases continuously from the central portion of the flexural oscillation region 182, the central portion being the antinode of the primary flexural mode, toward the edge of the flexural oscillation region 182, the edge being the node of the primary flexural mode. The adoption of such a film thickness distribution prevents an electrical breakdown because of the increased thickness of the piezoelectric/electrostrictive films 112 and 116 at the end portions of the electrode films 110, 114, and 118, and also reduces the stiffness of the piezoelectric/electrostrictive films 112 and 116 because of the reduced thicknesses of the piezoelectric/electrostrictive films 112 and 116 at the antinode of the primary flexural mode, thus resulting in an increase in the displacement of the piezoelectric/electrostrictive element 1.

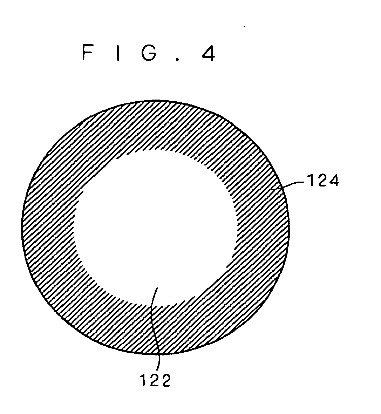

Crystal grains in the piezoelectric/electrostrictive films 112 and 116 should preferably have a core/shell structure with the shell portion 124 having a higher concentration of nickel than the core portion 122 and with the core portion 122 having a higher concentration of magnesium than the shell portion 124 as schematically illustrated in Fig. 4. This reduces oxygen vacancies in the shell portion 124, thus minimizing a change in the properties of the piezoelectric/electrostrictive films 112 and 116 after polarization and enhancing the insulating properties of the piezoelectric/electrostrictive films 112 and 116. This makes good use of the fact that nickel oxide has a nickel-deficient, i.e. oxygen-excessive non-stoichiometric composition $Ni_{1-\delta}O$.

<1-4. Electrode Films 110, 114, 118>

The electrode films 110, 114, and 118 are made of a conductive material. The conductive material for the electrode films 110 and 114 should preferably be platinum (Pt) or palladium (Pd), or an alloy consisting primarily of Pt or Pd. It is, however, to be noted that, if the piezoelectric/electrostrictive films 112 and 116 can be sintered together, the electrode films 110 and 114 may be made of any other conductive material. The conductive material for the electrode film 118 should preferably be gold (Au) or an alloy consisting primarily of Au.

As illustrated in Fig. 1, the electrode films 110 and 114 are opposed to each other with the piezoelectric/electrostrictive film 112 therebetween, and the electrode films 114 and 118 are opposed to each other with the piezoelectric/electrostrictive film 116 therebetween. The electrode film 110 and 118 are electrically connected to each other. This configuration allows the piezoelectric/electrostrictive films 112 and 116 to expand and contract upon the application of a drive signal between the electrode films 110, 118 as external electrodes and the electrode film 114 as an internal electrode, thus allowing flexural oscillations in the flexural oscillation region 182.

<1-5. Process for Producing Piezoelectric/Electrostrictive Element 1>

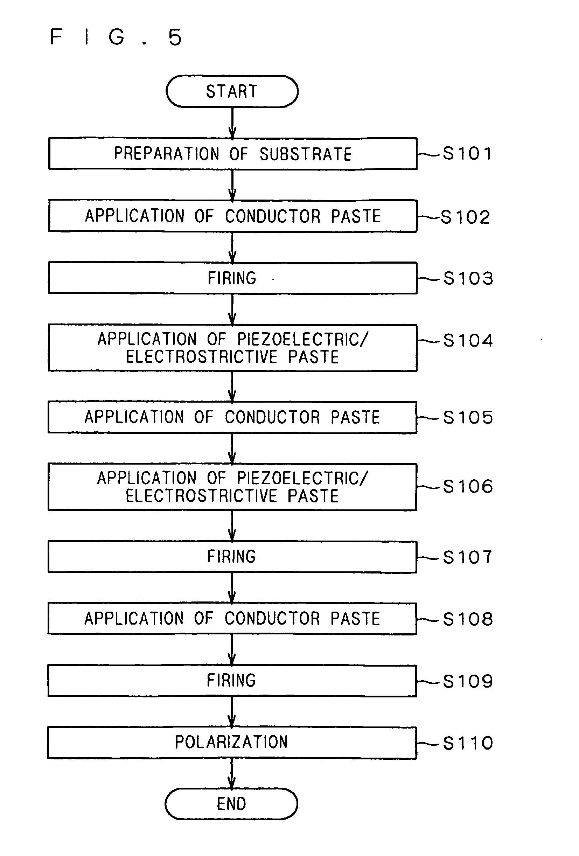

Fig. 5 is a flowchart for explaining a process for producing the piezoelectric/electrostrictive element 1.

As shown in Fig. 5, the production of the piezoelectric/electrostrictive element 1 firstly starts with the preparation of the substrate 102 (step S101).

Then, the laminated body 108 is formed on the thin portion 104 of the substrate 102 (steps S 102 to S 109).

For the formation of the laminated body 108, a conductor paste which is a kneaded product of a conductive material powder, an organic solvent, a dispersant, and a binder is applied by screen printing to the upper surface of the thin portion 104 (step S102), and the resulting coating film is fired integrally with the substrate 102 (step S103). This produces the electrode film 110 united with the substrate 102.

Then, a piezoelectric/electrostrictive paste which is a kneaded product of piezoelectric/electrostrictive material powder, an organic solvent, a dispersant, and a binder; a conductor paste; and another piezoelectric/electrostrictive paste are applied sequentially by screen printing to the upper surface of the electrode film 110 (steps S104, S105, and S106), and the resulting coating film is fired integrally with the substrate 102 and the electrode film 110 (step S107). This produces the piezoelectric/electrostrictive film 112, the electrode film 114, and the piezoelectric/electrostrictive film 116 united with the substrate 102 and the electrode film 110.

Thereafter, a conductor paste is applied by screen printing to the upper surface of the piezoelectric/electrostrictive film 116 (step S108), and the resultant coating film is fired integrally with the substrate 102, the electrode film 110, the piezoelectric/electrostrictive film 112, the electrode film 114, and the piezoelectric/electrostrictive film 116 (step S109). This produces the electrode film 118 united with the substrate 102, the electrode film 110, the piezoelectric/electrostrictive film 112, the electrode film 114, and the piezoelectric/electrostrictive film 116.

As the last step, polarization is induced by the application of voltage between the electrode films 110, 118 and the electrode film 114, which produces the piezoelectric/electrostrictive element 1.

<1-6. Process for Synthesizing Piezoelectric/Electrostrictive Material Powder>

A piezoelectric/electrostrictive material powder should preferably be synthesized firstly by the reaction of powders of raw materials for first elements selected from among B-site components, the first elements including magnesium and niobium and not including nickel, to form an intermediate powder and then by the reaction of the intermediate powder with powders of raw materials for second elements selected from among A-site and B-site components, the second elements including nickel and not including magnesium. The raw materials should preferably be oxides, but it may be compounds, such as hydroxides, carbonates, or tartrates, that turn into oxides during calcination.

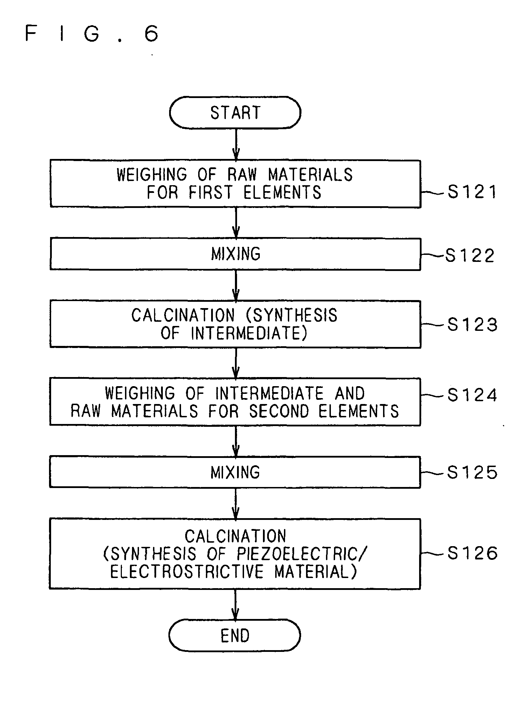

Now, a process for synthesizing a piezoelectric/electrostrictive material powder is described with reference to the flowchart in Fig. 6. The synthesis of a piezoelectric/electrostrictive material powder firstly starts with weighing of raw materials for the first elements selected from among the B-site components, the first elements including magnesium and niobium and not including nickel, so as to form a desired intermediate to be synthesized (step S121).

The weighed raw materials for the first elements are then mixed with the addition of a dispersion medium in a ball mill, a bead mill, an oscillating mill, or other mills, and the dispersion medium is removed by evaporation drying, filteration, or other techniques from the resulting slurry of a mixture of the raw materials for the first elements (step S122).

Thereafter, the mixture of the raw materials for the first elements is calcinated to initiate a reaction of the raw materials for the first elements, thereby synthesizing an intermediate (step S123). The synthesized intermediate powder may then be either grinded or classified to control a particle size distribution of the intermediate powder. It is also preferable that the synthesis of the intermediate be speeded up by performing calcination two or more times.

The most typical case is to synthesize a columbite compound ($MgNb_2O_6$) as an intermediate from magnesium and niobium as the first elements; however, it may also be possible to synthesize as an intermediate any other compound of magnesium and niobium oxides than a columbite compound, or a solid solution of magnesium and niobium oxides (e.g., $Mg_4Nb_2O_9$ or a solid solution of $MgNb_2O_6$ and $Ng_5Nb_4O_{15}$) As another alternative, the first elements may further include other B-site components except nickel. For instance, the first elements may include titanium and zirconium, and a compound or solid solution of magnesium, niobium, titanium, and zirconium oxides (i.e., a $MgO\text{-}Nb_2O_5\text{-}TiO_2\text{-}ZrO_2$ compound or solid solution) may be synthesized as an intermediate.

Next, the intermediate and the raw materials for second elements selected from among A-site and B-site components, the second elements including nickel and not including magnesium, are weighed so as to form a desired piezoelectric/electrostrictive material to be synthesized (step S124).

The weighed raw materials for the second elements and intermediate are then mixed with the addition of a dispersion medium in a ball mill, a bead mill, an oscillating mill, or other mills, and the dispersion medium is removed by evaporation drying, filteration, or other techniques from the resulting slurry of the mixture of the raw materials for the second elements and the intermediate (step S125).

Thereafter, the mixture of the raw materials for the second elements and the intermediate is calcinated to initiate a reaction of the intermediate and the raw materials for the second elements, thereby synthesizing a target piezoelectric/electrostrictive material (step S126). The synthesized piezoelectric/electrostrictive material powder may then be either grinded or classified to control a particle size distribution of the piezoelectric/electrostrictive material powder. It is also preferable that the synthesis of the piezoelectric/electrostrictive material be progressed by performing calcination two or more times.

This process for synthesizing a piezoelectric/electrostrictive material powder firstly synthesizes an intermediate containing magnesium and niobium and then synthesizes a target piezoelectric/electrostrictive material. This prevents a third component introduced in PZT (titanium lead zirconate) from having a varying composition among $Pb(Mg_{1/3}Nb_{2/3})O_3$, $Pb(Ni_{1/3}Nb_{2/3})O_3$, and $Pb\{(Mg, Nb)_{1/3}Nb_{2/3}\}O_3$, thus reducing variations in the durability of the piezoelectric/electrostrictive films. In other words, the first is the synthesis of $Pb(Mg_{1/3}Nb_{2/3})O_3$, the second is the reaction of $Pb(Mg_{1/3}Nb_{2/3})O_3$ with NiO, and the third is the substitution of Mg with Ni starting from the surface of the $Pb(Mg_{1/3}Nb_{2/3})O_3$ particles. This produces a core/shell structure with the shell portion 124 having a higher concentration of nickel than the core portion 122 and with the core portion 122 having a higher concentration of magnesium than the shell portion 124. If, on the other hand, no intermediate containing magnesium and niobium is synthesized, $Pb(Mg_{1/3}Nb_{2/3})O_3$, $Pb(Ni_{1/3}Nb_{2/3})O_3$, and $Pb\{(Mg, Nb)_{1/3}Nb_{2/3}\}O_3$ are all synthesized so that variations will occur in durability depending on the composition.

It is also preferable that the amounts of lead and nickel be increased at the time of weighing in consideration of the amount of evaporation, because a target composition may not be obtained due to evaporation of lead and nickel during firing. Increasing the amount of nickel also brings about the effect of accelerating the grain growth during firing.

<2. Second Preferred Embodiment>

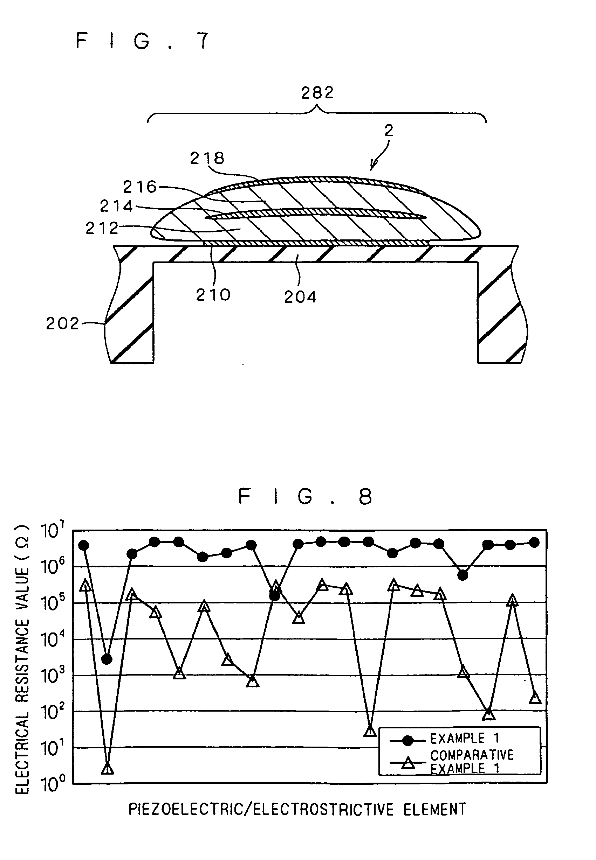

Fig. 7 is a diagrammatic illustration of the principal part of a piezoelectric/electrostrictive element 2 according to a second preferred embodiment of the invention, showing the piezoelectric/electrostrictive element 2 in cross section. Like the piezoelectric/electrostrictive element 1 described in the first preferred embodiment, the piezoelectric/electrostrictive element 2 in Fig. 7 is an actuator adopted in an inkjet printer head.

As illustrated in Fig. 7 and like the piezoelectric/electrostrictive element 1, the piezoelectric/electrostrictive element 2 has a laminated structure in which an electrode film 210, a piezoelectric/electrostrictive film 212, another electrode film 214, another piezoelectric/electrostrictive film 216, and another electrode film 218 are laminated in order of mention on a thin portion 204 of a substrate 202. The substrate 202, the electrode film 210, the piezoelectric/electrostrictive film 212, the electrode film 214, the piezoelectric/electrostrictive film 216, and the electrode film 218 of the piezoelectric/electrostrictive element 2 are configured in a similar way to the substrate 102, the electrode film 110, the piezoelectric/electrostrictive film 112, the electrode film 114, the piezoelectric/electrostrictive film 116, and the electrode film 118 of the piezoelectric/electrostrictive element 1, except in that the piezoelectric/electrostrictive films 212 and 216 have a different film thickness distribution from the piezoelectric/electrostrictive films 112 and 116.

The piezoelectric/electrostrictive films 212 and 216 have such a film thickness distribution that the film thickness decreases continuously from the central portion of a flexural oscillation region 282, the central portion being the antinode of the primary flexural mode, toward the edge of the flexural oscillation region 282, the edge being the node of the primary flexural mode, which distribution is the reverse of that of the piezoelectric/electrostrictive films 112 and 116.

In this piezoelectric/electrostrictive element 2, piezoelectric/electrostrictive films 212 and 236 formed of crystal grains having the core/shell structure in Fig. 4 are also produced by filing a film compact of a piezoelectric/electrostrictive material powder as described in the first preferred embodiment. The piezoelectric/electrostrictive films 212 and 236 can thus exhibit a small change in properties, high insulating properties, and narrow variations in durability.

<Examples>

Described hereinafter are EXAMPLE 1 according to the first preferred embodiment, and COMPARATIVE EXAMPLE 1 outside the scope of the present invention.

< EXAMPLE 1>

<Synthesis of Piezoelectric/Electrostrictive Material Powder>

In EXAMPLE 1, a magnesium carbonate ($MgCO_3$) powder and a niobium oxide ($Nb_2O_5$) powder, which are raw materials for magnesium and niobium, were weighed so as to obtain a Mg to Nb molar ratio of 1:2.
The weighed magnesium carbonate and niobium oxide were then mixed with the addition of water as a dispersion medium in a ball mill, and the resulting slurry of a mixture of magnesium carbonate and niobium oxide was dried by evaporation in a dryer to be dehydrated.
The mixture of magnesium carbonate and niobium oxide was then placed in an alumina ($Al_2O_3$) sagger and was calcined in an electric furnace at $950°C$ to synthesize a columbite compound ($MgNb_2O_6$) powder. The synthesized columbite compound was then added with water as a dispersion medium and was grinded in the ball mill. The resulting slurry of the grinded columbite compound was dried by evaporation in the dryer to be dehydrated.
Repeatedly, the grinded columbite compound was placed in the alumina sagger and was calcined at $950°C$ in the electric furnace to progress the synthesis of the columbite compound. The columbite compound was then added with water as a dispersion medium and was grinded in the ball mill. The resulting slurry of the grinded columbite compound was dried by evaporation in the dryer to be dehydrated.
Next, a lead oxide (PbO) powder, a nickel oxide (NiO) powder, a niobium oxide ($Nb_2O_5$) powder, a titanium oxide ($TiO_2$) powder, and a zirconium oxide ($ZrO_2$) powder, which are raw materials for lead, nickel, niobium, titanium, and zirconium; and the synthesized columbite compound powder were weighed to obtain a piezoelectric/electrostrictive material having a composition represented by the following formula: $0.20Pb\{(Mg_{0.87}Ni_{0.13})_{1/3}Nb_{2/3}\}O_3 - 0.43Pb_xTiO_3$-$0.37Pb_xZrO_3$.
The weighed columbite compound, lead oxide, nickel oxide, niobium oxide, titanium oxide, and zirconium oxide were then mixed with the addition of water as a dispersion medium in the ball mill. The resulting slurry of a mixture of the columbite compound, lead oxide, nickel oxide, niobium oxide, titanium oxide, and zirconium oxide was dried by evaporation in the drier to be dehydrated.
Thereafter, the mixture of the columbite compound, lead oxide, nickel oxide, niobium oxide, titanium oxide, and zirconium oxide was placed in a magnesia (MgO) sagger and was calcined in the electric furnace at $950 °C$ to synthesize a piezoelectric/electrostrictive material powder. The synthesized piezoelectric/electrostrictive material was added with water as a dispersion medium and was grinded in the ball mill, and the resulting slurry of the grinded piezoelectric/electrostrictive material was dried by evaporation in the drier to be dehydrated.

{Preparation of Piezoelectric/Electrostrictive Element 1}

Aside from the synthesis of a piezoelectric/electrostrictive material powder, the substrate 102 of yttria-stabilized zirconia is prepared. The thin portion 104 of the substrate 102 is rectangular in plane shape, having a size of 1.6 mm by 1.1 mm and a thickness of 6 $\mu m$.
Then, a platinum paste which was a kneaded product of a platinum powder, an organic solvent, a dispersant, and a binder was applied by screen printing on the flat upper surface of the thin portion 104 to form a coating film of the platinum paste. The coating film of the platinum paste is rectangular in plan shape in plane shape, having a size of 1.2 mm by 0.8 mm and a thickness of 3 $\mu m$.
The coating of the platinum paste was then placed and fired in the electric furnace at $1250°C$ for two hours.
Then, a piezoelectric/electrostrictive paste which was a kneaded product of the synthesized piezoelectric/electrostrictive material powder, an organic solvent, a dispersant, and a binder; a platinum paste; and another piezoelectric/electrostrictive paste were applied sequentially by screen printing to the upper surface of the electrode film 110 to form a coating film of the piezoelectric/electrostrictive paste, a coating film of the platinum paste, and another coating film of the piezoelectric/electrostrictive paste. The coating films of the piezoelectric/electrostrictive pastes are rectangular in plan shape, having a size of 1.3 mm by 0.9 mm and a thickness of 11 $\mu m$. The platinum paste used contains 0.6 parts by weight of cerium oxide to 100 parts by weight of the platinum powder and 20 parts by volume of the piezoelectric/electrostrictive material powder to 100 parts by volume of the platinum powder. The coating of the platinum paste has a thickness of 2 $\mu m$.

The coating film of the one piezoelectric/electrostrictive paste, the coating film of the platinum paste, and the coating film of the other piezoelectric/electrostrictive paste were then packed in the magnesia sagger and was placed and fired in the electric furnace at 1275°C for two hours. The piezoelectric/electrostrictive films 112 and 116 after firing have a thickness of 7 $\mu m$.

Then, a gold paste which was a kneaded product of a gold powder, an organic solvent, a dispersant, and a binder was applied by screen printing to the upper surface of the piezoelectric/electrostrictive film 112 to form a coating film of the gold paste. The coating film of the gold paste is rectangular in plane shape, having a size of 1.2 mm by 0.8 mm and a thickness of 0.5 $\mu m$.

The coating film of the gold paste was then fired in the electric furnace at 800°C for two hours.

As the last step, polarization was induced by the application of an electric field of 4 kV/mm to the piezoelectric/electrostrictive films 112 and 116, which has produced the piezoelectric/electrostrictive element 1.

Measurement of the flexural displacement of 20 piezoelectric/electrostrictive elements 1 prepared in this manner by the application of an electric field of 4 kV/mm to the piezoelectric/electrostrictive films 112 and 116 resulted in an average value of 2.0 $\mu m$.

Measurement of the electrical resistance value of those piezoelectric/electrostrictive elements 1 after a durability test, where an electric field of 4 kV/mm was applied to the piezoelectric/electrostrictive films 112 and 116 at a temperature of 80°C and a relative humidity of 80%RH for 24 consecutive hours, resulted in an average value of $3.3 \times 10^6$ $\Omega$. Fig. 8 plots the electrical resistance value (the vertical axis) after the durability test for each of the 20 piezoelectric/electrostrictive elements 1 (the horizontal axis) according to EXAMPLE 1. As shown in Fig. 8, in EXAMPLE 1, three out of the 20 piezoelectric/electrostrictive elements 1 have electrical resistance values less than $10^6$ $\Omega$.

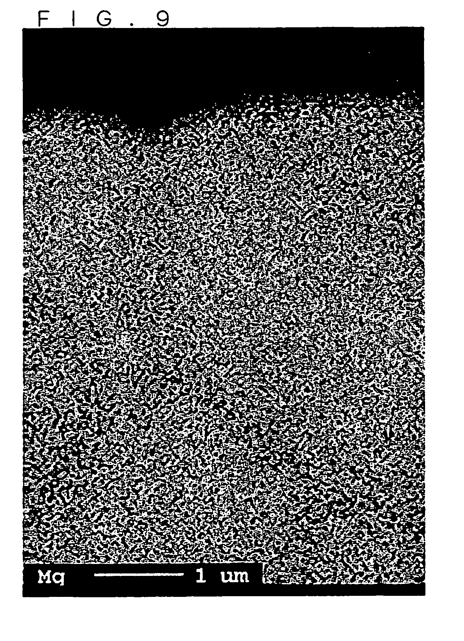

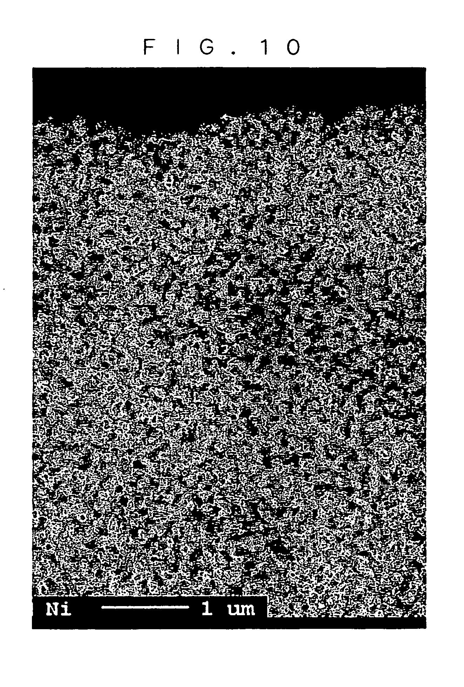

Further, the cross sections of the piezoelectric/electrostrictive elements 1 were mirror-polished, and the magnesium and nickel distributions in the cross sections of the piezoelectric/electrostrictive elements 1 were examined through EPMA (Electron Probe Micro Analysis). The results were shown in Figs. 9 and 10. In the mapping images in Figs. 9 and 10, the white part represents a high element concentration. The mapping images viewed from the same angle in Fig. 9 and 10 have shown that crystal grains in the piezoelectric/electrostrictive films 112 and 116 have a core/shell structure in which the shell portion closer to the grain boundary has a higher concentration of nickel than the core portion further away from the grain boundary, while the core portion further away from the grain boundary has a higher concentration of magnesium than the shell portion closer to the grain boundary.

<COMPARATIVE EXAMPLE 1>

In COMPARATIVE EXAMPLE 1, lead oxide, magnesium carbonate, nickel oxide, niobium oxide, titanium oxide, and zirconium oxide were weighed to obtain a piezoelectric/electrostrictive material having a composition represented by the following formula: $0.20Pb\{(Mg_{0.87}Ni_{0.13})_{1/3}Nb_{2/3}\}O_3 - 0.43Pb_xTiO_3 - 0.37Pb_xZrO_3$.

Then, the weighed lead oxide powder, magnesium carbonate powder, nickel oxide powder, niobium oxide powder, titanium oxide powder, and zirconium oxide powder were mixed with the addition of water as a dispersion medium in the ball mill, and the resulting slurry of a mixture of lead oxide, magnesium carbonate, nickel oxide, niobium oxide, titanium oxide, and zirconium oxide was dried by evaporation in a drier to be dehydrated.

The mixture of lead oxide, magnesium carbonate, nickel oxide, niobium oxide, titanium oxide, and zirconium oxide was then placed in a magnesia sagger and was calcinated in an electric furnace at 950°C to synthesize a piezoelectric/electrostrictive material powder. The synthesized piezoelectric/electrostrictive material powder was added with water as a dispersion medium and was grinded in the ball mill, and the resulting slurry of the grinded piezoelectric/electrostrictive material was dried by evaporation in the dryer to be dehydrated.

Using the piezoelectric/electrostrictive material powder prepared in this manner, a piezoelectric/electrostrictive element was prepared as described in EXAMPLE 1. Similar measurement of the flexural displacement of 20 piezoelectric/electrostrictive elements to that in the EXAMPLE 1 resulted in an average value of 1.6 $\mu m$. Also similar measurement of the electrical resistance value of the 20 piezoelectric/electrostrictive elements after the durability test to that in the EXAMPLE 1 resulted in an average value of $1.2 \times 10^5$ $\Omega$. Fig. 8 plots the electrical resistance value (the vertical axis) after the durability test for each of the 20 piezoelectric/electrostrictive elements (the horizontal axis) in COMPARATIVE EXAMPLE 1. As shown in Fig. 8, in COMPARATIVE EXAMPLE 1, the electrical resistance values of the 20 piezoelectric/electrostrictive elements after the durability test were all less than $10^6$ $\Omega$ , and more specifically, 11 out of 20 were less than $10^5$ $\Omega$.

< Comparison between EXAMPLE 1 and COMPARATIVE EXAMPLE 1>

As is evident from the comparison between EXAMPLE 1 and COMPARATIVE EXAMPLE 1, the use of a piezoelectric/electrostrictive material powder synthesized from a columbite compound for the preparation of the piezoelectric/electrostrictive element 1 achieves the core/shell structure of crystal grains in the piezoelectric/electrostrictive films 112 and 116. This increases the amount of flexural displacement and the electrical resistance value after the durability test.

<Modifications>

While the invention has been shown and described in detail, the foregoing description is in all aspects illustrative and not restrictive. It is therefore understood that numerous modifications and variations can be devised without departing from the invention as defined by the claims. In particular, it is also understood that any combination of the techniques described in the first and second preferred embodiments will be apparent to those skilled in the art.

**Claims**

1. A piezoelectric/electrostrictive ceramic comprising:

   a perovskite oxide containing lead as an A-site component and magnesium, nickel, niobium, titanium, and zirconium as B-site components,
   **characterised in that** crystal grains in the piezoelectric/electrostrictive ceramic have a core/shell structure with a shell portion having a higher concentration of nickel than a core portion and with the core portion having a higher concentration of magnesium than the shell portion.

2. The piezoelectric/electrostrictive ceramic according to claim 1, wherein
   its composition is represented by the general formula:

$$aPb_x\left\{\left(Mg_{1-y}Ni_y\right)_{z/3}Nb_{2/3}\right\}O_3 - bPb_xTiO_3 - cPb_xZrO_3 \ ,$$

   where

$$(a + b + c) = 1 \, ,$$

$$0.95 \leq x \leq 1.10$$

$$0.05 \leq y \leq 0.50$$

$$0.90 \leq z \leq 1.10 \, ,$$

   and
   the ratio of composition (*a, b, c*) falls within the range defined by five points (0.550, 0.425, 0.025), (0.550, 0.325, 0.125), (0.050, 0.425, 0.525), (0.050, 0.525, 0.425), and (0.375, 0.425, 0.200) in a ternary diagram.

3. The piezoelectric/electrostrictive ceramic according to claim 1, wherein
   its principal component contains 0.1 to 3.0 percent by mass of NiO,
   the principal component having a composition represented by the general formula:

$$aPb_x\left(Mg_{y/3}Nb_{2/3}\right)O_3 - bPb_xTiO_3 - cPb_xZrO_3 \ ,$$

where

$$(a + b + c) = 1,$$

$$0.95 \leq x \leq 1.10$$

$$0.90 \leq y \leq 1.10,$$

and

the ratio of composition ($a,b,c$) falls within the range defined by six points (0.550, 0.425, 0.025), (0.550, 0.325, 0.125), (0.375, 0.325, 0.300), (0.050, 0.425, 0.525), (0.050, 0.525, 0.425), and (0.375, 0.425, 0.200) in a ternary diagram.

4. A process for producing a piezoelectric/electrostrictive ceramic, comprising the steps of:

(a) initiating a reaction between raw materials for first elements selected from among B-site components to form an intermediate, the first elements including magnesium and niobium and not including nickel; and
(b) initiating a reaction between the intermediate synthesized in said step (a) and a raw material for a second element selected from among A-site and B-site components, the second element including nickel and not including magnesium,

wherein said steps (a) and (b) produce a piezoelectric/electrostrictive ceramic that comprises a perovskite oxide containing lead as an A-site component and magnesium, nickel, niobium, zirconium, and titanium as B-site components.

5. The process for producing a piezoelectric/electrostrictive ceramic according to claim 4, wherein
the first elements are magnesium and niobium, and
the intermediate synthesized in said step (a) is a columbite compound.

**Patentansprüche**

1. Piezoelektrische/elektrostriktive Keramik, die Folgendes umfasst:

ein Perowskitoxid, enthaltend Blei als A-Stellen-Komponente und Magnesium, Nickel, Niob, Titan und Zirconium als B-Stellen-Komponenten,
**dadurch gekennzeichnet, dass** Kristallkörner in der piezoelektrischen/elektrostriktiven Keramik eine Kern-Hülle-Struktur aufweisen, bei der der Hüllenteil eine höhere Nickelkonzentration aufweist als der Kernteil und der Kernteil eine höhere Magnesiumkonzentration aufweist als der Hüllenteil.

2. Piezoelektrische/elektrostriktive Keramik nach Anspruch 1, worin deren Zusammensetzung durch die allgemeine Formel

$$aPb_x \left\{ \left( Mg_{1-y}Ni_y \right)_{1/3} Nb_{2/3} \right\} O_3 - bPb_x TiO_3 - cPb_x ZrO_3$$

dargestellt ist,
wobei (a + b + c) = 1 ist,

$$0,95 \le x \le 1,10$$

ist,

$$0,05 \le y \le 0,50$$

ist,

$$0,90 \le z \le 1,10$$

ist und das Verhältnis der Zusammensetzung (a, b, c) in den durch die fünf Punkte (0,550, 0,425, 0,025), (0,550, 0,325, 0,125), (0,050, 0,425, 0,525), (0,050, 0,525, 0,425) und (0,375, 0,425, 0,200) definierten Bereich in einem ternären Diagramm fällt.

3. Piezoelektrische/elektrostriktive Keramik nach Anspruch 1, worin
deren Hauptkomponente 0,1 bis 3,0 Massen-% NiO enthält,
wobei die Hauptkomponente eine durch die allgemeine Formel

$$aPb_x\left(Mg_{y/3}Nb_{2/3}\right)O_3 - bPb_xTiO_3 - cPb_xZrO_3$$

dargestellte Zusammensetzung aufweist,
wobei (a + b + c) = 1 ist,

$$0,95 \le x \le 1,10$$

ist,

$$0,90 \le y \le 1,10$$

ist und das Verhältnis der Zusammensetzung (a, b, c) in den durch die sechs Punkte (0,550, 0,425, 0,025), (0,550, 0,325, 0,125), (0,375, 0,325, 0,300), (0,050, 0,425, 0,525), (0,050, 0,525, 0,425) und (0,375, 0,425, 0,200) definierten Bereich in einem ternären Diagramm fällt.

4. Verfahren zur Herstellung einer piezoelektrischen/elektrostriktiven Keramik, das die folgenden Schritte umfasst:

(a) das Einleiten einer Reaktion zwischen Rohmaterialien für aus B-Stellen-Komponenten ausgewählte erste Elemente zum Bilden eines Zwischenprodukts, wobei die ersten Elemente Magnesium und Niob umfassen und Nickel nicht umfassen; und
(b) das Einleiten einer Reaktion zwischen dem in Schritt (a) synthetisierten Zwischenprodukt und einem Rohmaterial für ein aus A-Stellen- und B-Stellen-Komponenten ausgewähltes zweites Element, wobei das zweite Element Nickel umfasst und Magnesium nicht umfasst,

worin die Schritte (a) und (b) eine piezoelektrische/elektrostriktive Keramik hervorbringen, die ein Perowskitoxid umfasst, das Blei als A-Stellen-Komponente und Magnesium, Nickel, Niob, Zirconium und Titan als B-Stellen-Komponenten enthält.

**5.** Verfahren zur Herstellung einer piezoelektrischen/elektrostriktiven Keramik nach Anspruch 4, worin
die ersten Elemente Magnesium und Niob sind und
das in Schritt (a) synthetisierte Zwischenprodukt eine Columbitverbindung ist.

**Revendications**

**1.** Céramique piézoélectrique/électrostrictive comprenant:

un oxyde de perovskite contenant du plomb en tant que composant de site A et du magnésium, du nickel, du niobium, du titane et du zirconium en tant que composants de site B,
**caractérisée en ce que** des grains cristallins dans la céramique piézoélectrique/électrostrictive ont une structure coeur/gaine dont la partie gaine a une concentration de nickel supérieure à celle de la partie coeur, et la partie coeur a une concentration de magnésium supérieure à celle de la partie gaine.

**2.** Céramique piézoélectrique/électrostrictive selon la revendication 1, dont la composition est représentée par la formule générale :

$$aPb_x\{(Mg_{1-y}Ni_y)_{z/3}Nb_{2/3}\}O_3 - bPb_xTiO_3 - cPb_xZrO_3$$

dans laquelle (a + b + c) = 1,

$$0,95 \leq x \leq 1,10,$$

$$0,05 \leq y \leq 0,50,$$

$$0,90 \leq z \leq 1,10,$$

et
le rapport de composition (a,b,c) est situé dans la plage définie par cinq points (0,550, 0,425, 0,025), (0,550, 0,325, 0,125), (0,050, 0,425, 0,525), (0,050, 0,525, 0,425), et (0,375, 0,425, 0,200) dans un diagramme ternaire.

**3.** Céramique piézoélectrique/électrostrictive selon la revendication 1, dont le composant principal contient 0,1 à 3,0 % en masse de NiO,
le composant principal ayant une composition représentée par la formule général :

$$aPb_x(Mg_{y/3}Nb_{2/3})O_3 - bPb_xTiO_3 - cPb_xZrO_3$$

dans laquelle (a + b + c) = 1,

$$0,95 \leq x \leq 1,10,$$

$$0,90 \leq y \leq 1,10,$$

le rapport de composition (a,b,c) est situé dans la plage définie par six points (0,550, 0,425, 0,025), (0,550, 0,325, 0, 125), (0,375, 0,325, 0, 300), (0,050, 0,425, 0,525), (0,050, 0,525, 0,425), et (0,375, 0,425, 0,200) dans un diagramme ternaire.

4. Procédé pour produire une céramique piézoélectrique/électrostrictive, comprenant les étapes consistant à :

(a) initier une réaction entre des matières premières pour des premiers éléments choisis parmi les composants de site B pour former un intermédiaire, les premiers éléments comprenant du magnésium et du niobium et ne comprenant pas de nickel ; et
(b) initier une réaction entre l'intermédiaire synthétisé dans ladite étape (a) et une matière première pour un deuxième élément choisi parmi les composants de site A et de site B, le deuxième élément comprenant du nickel et ne comprenant pas de magnésium ;

dans lequel lesdites étapes (a) et (b) produisent une céramique piézoélectrique/électrostrictive qui comprend un oxyde de perovskite contenant du plomb en tant que composant de site A et du magnésium, du nickel, du niobium, du titane et du zirconium en tant que composants de site B.

5. Procédé pour produire une céramique piézoélectrique/électrostrictive selon la revendication 4, dans lequel les premiers éléments sont le magnésium et le niobium, et l'intermédiaire synthétisé dans ladite étape (a) est un composé de columbite.

F I G . 1

F I G . 2

$Pb_x\{(Mg_yNi_{1-y})_{z/3}Nb_{2/3}\}O_3$

b

A    B

E

D  C

a

$Pb_xTiO_3$

c

$Pb_xZrO_3$

F I G . 3

F I G . 4

124

122

F I G . 5

```
            ┌──────────────┐
            │    START     │
            └──────┬───────┘
                   ↓
┌──────────────────────────────────┐
│     PREPARATION OF SUBSTRATE     │─S101
└──────────────────┬───────────────┘
                   ↓
┌──────────────────────────────────┐
│    APPLICATION OF CONDUCTOR PASTE │─S102
└──────────────────┬───────────────┘
                   ↓
┌──────────────────────────────────┐
│             FIRING               │─S103
└──────────────────┬───────────────┘
                   ↓
┌──────────────────────────────────┐
│  APPLICATION OF PIEZOELECTRIC/   │─S104
│     ELECTROSTRICTIVE PASTE       │
└──────────────────┬───────────────┘
                   ↓
┌──────────────────────────────────┐
│   APPLICATION OF CONDUCTOR PASTE │─S105
└──────────────────┬───────────────┘
                   ↓
┌──────────────────────────────────┐
│  APPLICATION OF PIEZOELECTRIC/   │─S106
│     ELECTROSTRICTIVE PASTE       │
└──────────────────┬───────────────┘
                   ↓
┌──────────────────────────────────┐
│             FIRING               │─S107
└──────────────────┬───────────────┘
                   ↓
┌──────────────────────────────────┐
│   APPLICATION OF CONDUCTOR PASTE │─S108
└──────────────────┬───────────────┘
                   ↓
┌──────────────────────────────────┐
│             FIRING               │─S109
└──────────────────┬───────────────┘
                   ↓
┌──────────────────────────────────┐
│          POLARIZATION            │─S110
└──────────────────┬───────────────┘
                   ↓
            ┌──────────────┐
            │     END      │
            └──────────────┘
```

F I G . 6

```
              ┌──────────────┐
              │    START     │
              └──────┬───────┘
                     │
                     ▼
       ┌─────────────────────────────┐
       │  WEIGHING OF RAW MATERIALS   │──S121
       │      FOR FIRST ELEMENTS      │
       └─────────────┬───────────────┘
                     │
                     ▼
       ┌─────────────────────────────┐
       │           MIXING            │──S122
       └─────────────┬───────────────┘
                     │
                     ▼
       ┌─────────────────────────────┐
       │    CALCINATION (SYNTHESIS    │──S123
       │      OF INTERMEDIATE)        │
       └─────────────┬───────────────┘
                     │
                     ▼
       ┌─────────────────────────────┐
       │  WEIGHING OF INTERMEDIATE AND │──S124
       │ RAW MATERIALS FOR SECOND ELEMENTS │
       └─────────────┬───────────────┘
                     │
                     ▼
       ┌─────────────────────────────┐
       │           MIXING            │──S125
       └─────────────┬───────────────┘
                     │
                     ▼
       ┌─────────────────────────────┐
       │         CALCINATION          │
       │ (SYNTHESIS OF PIEZOELECTRIC/  │──S126
       │   ELECTROSTRICTIVE MATERIAL)  │
       └─────────────┬───────────────┘
                     │
                     ▼
              ┌──────────────┐
              │     END      │
              └──────────────┘
```

F I G . 7

F I G . 8

PIEZOELECTRIC/ELECTROSTRICTIVE ELEMENT

FIG. 9

Mg ——————— 1 um

F I G . 1 0

**EP 2 086 030 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002100819 A
- JP 2000247737 A
- JP 2007204336 A
- EP 1191611 A2

**Non-patent literature cited in the description**

- **TIEN-I CHANG et al.** The Formation Mechanism of the Novel Core-Shell Microstructure in Polyvinyl Alcohol-Additive Lead Zirconate Titanate Films. *J. Am. Ceram. Soc.,* 2007, vol. 90, 1051-1057